# EUROPEAN PATENT SPECIFICATION

(11) **EP 2 200 098 B1**
(45) Date of publication and mention of the grant of the patent: **14.12.2011**
(21) Application number: 08837228.9
(22) Date of filing: 09.10.2008
(51) Int. Cl.: H01L 31/20, C23C 14/56, H01L 31/18

(54) **PRODUCTION SYSTEM OF THIN FILM SOLAR BATTERY**
SYSTEM ZUR HERSTELLUNG EINER DÜNNSCHICHTSOLARBATTERIE
SYSTÈME DE PRODUCTION DE PILE SOLAIRE À FILM MINCE

(30) Priority: 11.10.2007 JP 2007265537
(43) Date of publication of application: 23.06.2010
(73) Proprietor: Fuji Electric Co., Ltd., Kawasaki-shi Kanagawa (JP)
(72) Inventor: SAKAI, Ryohei, Tokyo 141-0032 (JP)
(74) Representative: MERH-IP Matias Erny Reichl Hoffmann
(86) International application number: PCT/JP2008/068373
(87) International publication number: WO 2009/048104

(56) References cited:
- WO-A2-2005/001157
- JP-A- 2001 072 291
- JP-A- 2001 072 291
- JP-A- 2001 114 461
- JP-A- 2001 114 461
- JP-A- 2001 230 430
- JP-A- 2003 258 280
- JP-A- 2003 258 280
- JP-U- 1 088 662
- US-A- 4 476 636

## Description

### TECHNICAL FIELD

This invention relates to an apparatus for manufacturing thin film solar cells, in which a metal thin film which becomes an electrode is formed on the surface of a strip-shape flexible film substrate, more specifically, this invention relates to an apparatus for manufacturing thin film solar cells in which means for transporting the film substrate is improved, and the occurrence of transport wrinkles in the film substrate due to rollers is prevented.

### BACKGROUND ART

Currently research and development of clean energy is being pursued, in the interest of environmental protection. Among this, solar cells are attracting interest by virtue of the unlimited resources (sunlight) involved and the fact that they are pollution-free.

Thin film solar are thin, lightweight, have low manufacturing costs, and can easily be manufactured with large areas, and so are regarded as the future mainstream of solar cells.

Conventional thin film solar cells have used glass substrates, but research and development of flexible type solar cells which use lightweight, workable, mass-producible plastic film or metal film, is being pursued. Exploiting this flexibility, mass production using roll-to-roll or stepping roll manufacturing methods is possible.

In the above thin film solar cells, a plurality of photoelectric conversion elements (or cells), in which a metal electrode layer, photoelectric conversion layer comprising a thin film semiconductor layer, and transparent electrode layer are layered, are formed on a flexible electrically insulating film. By repeating electrical connections between the metal electrode of a certain photoelectric conversion element and the transparent electrode of an adjacent photoelectric conversion element, the required voltage can be caused to be output across the metal electrode of the first photoelectric conversion element and the transparent electrode of the last photoelectric conversion element.

Such photoelectric conversion elements and series connections thereof are formed using film deposition of electrode layers and photoelectric conversion layers, as well as patterning of each layer, and a procedure for combining these. The configuration and method of manufacture of the above solar cells are for example described in Patent References 1 and 2.

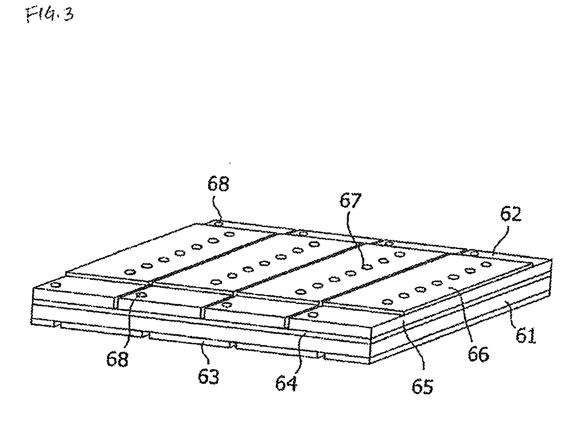

Fig. 3 is a conceptual diagram of the configuration of a thin film solar cell described in Patent Reference 2. Fig. 3 shows a perspective view of a flexible thin film solar cell employing plastic film as the substrate. The photoelectric conversion elements 62 formed on the surface of the substrate 61 and the connecting electrode layer 63 formed on the rear surface of the substrate 61 are each completely separated into a plurality of units, and the separation positions are respectively shifted.

Consequently two elements are series-connected such that the current generated in the photoelectric conversion layer 65, which is an amorphous semiconductor portion of the element 62, is first collected in the transparent electrode layer 66, and next, via current collection holes 67 formed in the transparent electrode layer region passes to the back-surface connection electrode layer 63, and then, via connection holes 68 for series connection formed on the outside of the transparent electrode layer region of the element in the connection electrode layer region, reaches the lower electrode layer 64 extending to the outside of the transparent electrode layer region of the element adjacent to the element.

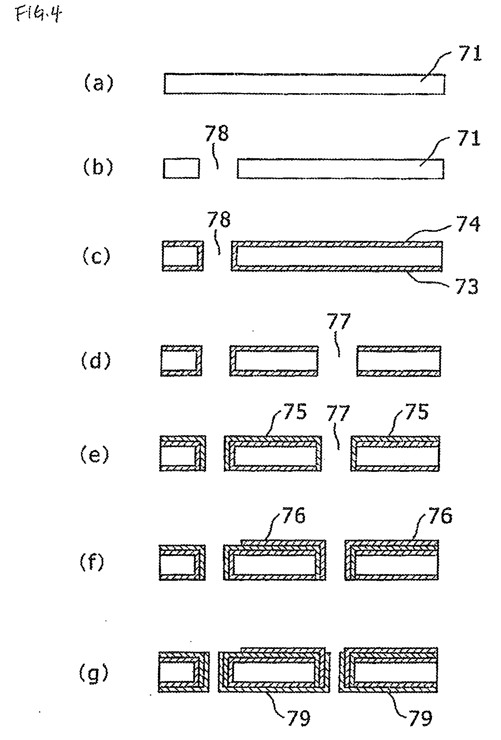

Simplified manufacturing processes for the above thin film solar cells appear in (a) through (g) of Fig. 4. Using a plastic film 71 as the substrate (process (a)), connection holes 78 are formed therein (process (b)), and then a first electrode layer (lower electrode) 74 and third electrode layer (a portion of the connecting electrode) 73 are formed on the two faces of the substrate (process (c)), after which current collection holes 77 are formed, at positions removed a prescribed distance from the connection holes 78 (process (d)). Formation of the first electrode layer 74 and third electrode layer 73 in the above process (c) is performed in a film deposition apparatus, described below, with the substrate 71 inverted and divided into two stages, and the portion of the connecting holes 78 formed by growing the two electrode layers 74 and 73. By this means, electrical connection of the two electrode layers is obtained.

Next, the semiconductor layer 75 which becomes the photoelectric conversion layer and the transparent electrode layer 76 which is the second electrode layer are formed in order on the first electrode layer 74 (process (e) and process (f)), and in addition a fourth electrode layer (connecting electrode layer) 79 is formed on the third electrode layer 73 (process (g)). Then, a laser beam is used to separate the thin film on both sides of the substrate 71 and form a series-connected structure, as shown in Fig. 3.

In the processes of Fig. 4, processing of the substrate is performed in air in the processes (a), (b) and (d), but the other processes are performed in a vacuum film deposition apparatus, described below. Hence in the case of the above processes, after processing the substrate in air in the later processes (b) and (d), the substrate is introduced into the vacuum container of the vacuum film deposition apparatus. Formation of the first electrode layer 74 and third electrode layer 73 in the above process (c) is performed with the substrate 71 inverted and divided into two stages, so that after the inversion, the substrate is first exposed to air, and then once again introduced into the vacuum container.

As the method of manufacture of the thin film of thin film solar cells, as explained above, roll-to-roll methods and stepping roll methods may be used. In both methods, substrate transport means using a plurality of rollers is comprised; in the former, film is deposited continuously onto substrate which moves continuously within each of the film deposition chambers, and in the latter, film deposition onto the halted substrate is performed simultaneously in each of the film deposition chambers, and after the end of film deposition the substrate portions are fed to the next film deposition chambers.

A stepping roll type film deposition apparatus is superior in that, because gas interdiffusion between adjacent film deposition chambers can be prevented, stable characteristics for each of the thin films can be obtained; the configuration of such an apparatus is for example described in Patent References 3 and 4.

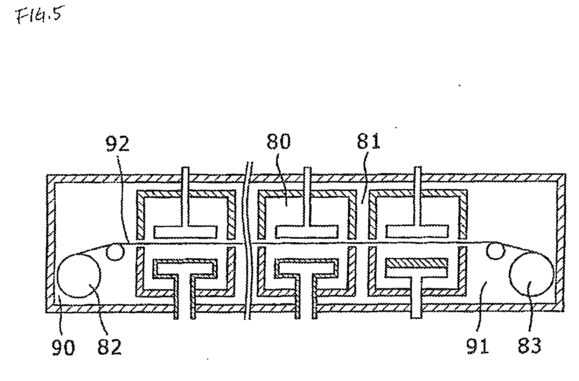

Fig. 5 shows an example of a stepping roll film deposition type vacuum film deposition apparatus, having a plurality of film deposition chambers within a common vacuum chamber. The apparatus shown in Fig. 5 comprises an unwinder chamber 90 for feedout of the flexible substrate; a plurality of film deposition chambers 80 as independent processing spaces, to form the metal electrode layer, photoelectric conversion layer, transparent electrode layer, and similar; and, a winder chamber 91 for takeup. After being fed out from the core 82 and before being taken up by the core 83, films are deposited on the substrate 92 in the plurality of film deposition chambers 80. The common chamber 81 accommodates the plurality of film deposition chambers 80 therewithin.

In the film deposition chambers, film deposition is performed by a plasma chemical vapor deposition method (hereafter "plasma CVD method") or similar. For example, in a stepping roll method in which films are deposited by a plasma CVD method, operations comprising film deposition chamber opening; substrate frame movement; film deposition chamber sealing; raw material gas introduction; pressure control; discharge initiation; discharge termination; raw material gas cessation; gas evacuation; and film deposition chamber opening, are repeated.

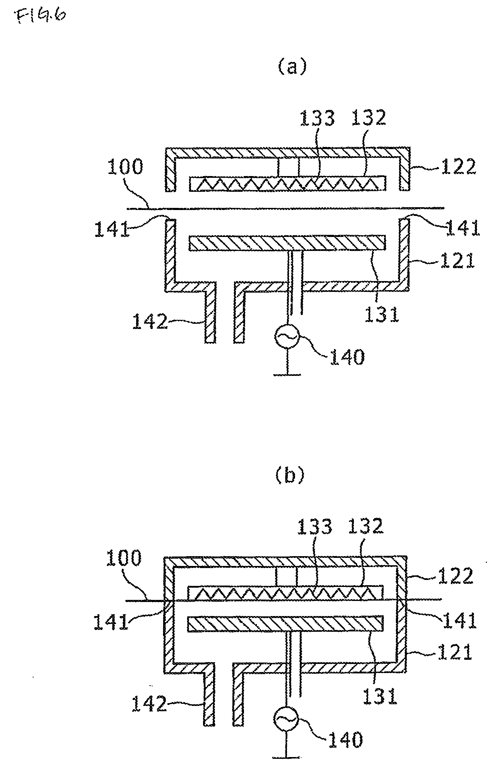

Fig. 6 shows an example of the summary structure of a film deposition chamber as described in Patent Reference 4 . In Fig. 6, (a) and (b) respectively show summary cross-sectional diagrams when the film deposition chamber is opened, and when it is sealed. A box-shape lower film deposition chamber housing 121 and upper film deposition chamber housing 122 are positioned in opposition below and above the flexible substrate 100, which is transported intermittently, configured such that, when the film deposition chamber is sealed, an independent processing space is formed by the lower film deposition chamber and the upper film deposition chamber. In this example, the lower film deposition chamber comprises a high-voltage electrode 131 connected to a power supply 140, and the upper film deposition chamber comprises a ground electrode 132 incorporated within a heater 133.

As shown in (b) of Fig. 6, during film deposition the upper film deposition chamber housing 122 is lowered, and the ground electrode 132 presses against the substrate 100 and causes the electrode 100 to make contact with seal members 141 mounted on the opening-side edge faces of the lower film deposition chamber housing 121. In this way, a film deposition space 143, linked with the exhaust tube 142 and hermetically sealed, is forced from the lower film deposition chamber housing 121 and the substrate 100. In the above-described film deposition chamber, by applying a high-frequency voltage to the high-voltage electrode 131, plasma is generated in the film deposition space 143, and raw material gas introduced from an introduction tube, not shown, is decomposed so that, for example, a film of a photoelectric conversion layer can be formed on the substrate 100.

On the other hand, the roll-to-roll method is superior with respect to productivity, because the substrate is moved continuously between rollers provided in a horizontal direction or between rollers provided in the vertical direction on different levels, and a plurality of film deposition tasks are performed continuously. Such an apparatus configuration, in which the substrate is moved continuously to a roller provided on a different level in the vertical direction, is for example described in Patent Reference 5.

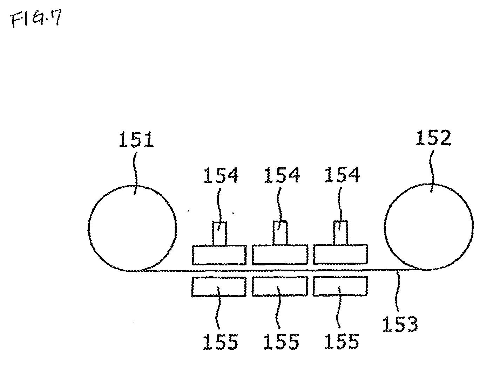

Fig. 7 shows the summary configuration of a sputtering film deposition apparatus in a configuration of a roll-to-roll apparatus in which the substrate is moved continuously between rollers provided in a horizontal direction. The reaction chamber as a vacuum chamber, the vacuum evacuation system, the sputtering gas supply system, and similar are omitted.

The electrode formation apparatus shown in Fig. 7 is likewise the type in which the film substrate is transported horizontally, and the film substrate feedout roller 151 and takeup roller 152 are also positioned horizontally. In the apparatus shown in Fig. 7, the film substrate 153 is transported between heaters 154 which also serve as ground electrodes and application electrodes 155 which have targets. The film substrate 153 is heated in contact-free fashion by the heaters from the rear surface side, while electrode formation is performed by sputtering.

In the electrode formation apparatuses shown in Fig. 7, an example is shown in which a plurality of (three) targets are provided; this is an example in which an electrode layer is formed as a layered film of a plurality of layers, and when for example formation employs silver or another single metal, only one target is needed.

By means of the apparatus shown in Fig. 7, electrode formation on one surface of the film substrate is possible in a single film substrate transport operation. When forming an electrode on both surfaces, after the end of electrode formation on one surface, the apparatus is exposed to air, the film substrate is inverted and set, vacuum evacuation is again performed, and then, after degasifying the film substrate, electrode formation is performed.

However, when transporting such a film substrate, because the film substrate width is substantial, due to the occurrence of slackness, wrinkles or similar during transport, a method is adopted in which the feedout roller and takeup roller axes of the film substrate are made vertical, and the film substrate is transported in a vertical state. In this case, the film substrate is transported between heaters also serving as ground electrodes and application electrodes having targets, and electrode formation is performed.

In such film deposition chambers to deposit electrode layers, in a state of vacuum induced by a vacuum pump, and in a state of being heated to approximately 300°C by the heaters, film deposition As performed (Patent Reference 6).
Patent Reference 1: Japanese Patent Application Laid-open No. H10-233517
Patent Reference 2: Japanese Patent Application Laid-open No. 2000-223727
Patent Reference 3: Japanese Patent Application Laid-open No. H6-291349
Patent Reference 4: Japanese Patent Application Laid-open No. H8-250431
Patent Reference 5: Japanese Examined Patent Publication No. H7-38378
Patent Reference 6: Japanese Patent Application Laid-open No. 2000-301139

The film deposition chamber to form this electrode layer is divided into a plurality of film deposition chambers, and the film substrate is transported at constant speed and tension and taken up by the takeup roller by means of a feed roller and press roller provided in the takeup chamber. Because film is deposited onto the film substrate at a high temperature of approximately 300°C by means of a heater in the former-stage film deposition chamber, the film substrate temperature is always approximately 177°C, and when transporting the film substrate by means of a feed roller and press roller with the film substrate surface in this heated state, transport wrinkles occur.

In particular, when an electrode which becomes the current-generating layer side (also called the rear surface) is provided on one surface of the film substrate, during film manufacture to form an electrode on the opposite side (also called the back surface), because the radiation rate of the electrode surface on which the electrode is provided is low compared with the film surface, the temperature hysteresis of the film during back surface film fabrication differs substantially compared with during rear surface film fabrication, and the film temperature is not readily lowered. And, while in the state of a high film temperature, tension on the surface of the film substrate due to the feed roller and press roller causes the tension distribution in the width direction to be non-uniform, so that there has been the problem that transport wrinkles have occurred.

JP 2003 258280 A discloses a device for manufacturing a thin film solar battery that is equipped with a substrate temperature fluctuation reducing means for reducing ascending or descending fluctuation in the temperature of a film substrate heated in an upstream processing process, in one or more portions of a role transfer process between an unwinding chamber of a film substrate and an winding chamber.

JP 2001/072291 A discloses a guide roller device capable of improving the quality of a sheet-shape supporting body in which rubber sheets are used on parts kept into contact with both side parts of the sheet-shaped supporting body.

In particular, in vertical transport in which transport is performed in an attitude in which the film substrate width direction is directed in the vertical direction, there is also deformation due to the weight of the film substrate itself, so that transport wrinkles become larger still.

This invention has as an object resolution of the above problem, by provision of a thin film solar cell manufacturing apparatus which prevents the occurrence of transport wrinkles due to driving rollers which transport the thin film, while enabling improved workability.

### DISCLOSURE OF THE INVENTION

This object of the invention is achieved by the subject-matter according to the independent claim 1. The dependent claim refers to a preferred embodiment of the invention.

In order to resolve the above problems, in a thin film solar cell manufacturing apparatus of this invention, a strip-shape flexible film substrate wrapped around a feedout roller is fed to a film deposition chamber maintained substantially in a vacuum state, electric discharge is induced across ground electrodes positioned to oppose each other and application electrodes having target material in the film deposition chamber, metal thin film, which becomes an electrode, is formed on the surface of the film substrate by constant heating, and the film substrate with metal thin film formed is taken up by a takeup roller provided in a takeup chamber; in the takeup chamber a pair of driving rollers which transport, at constant tension, the film substrate formed with metal thin film are provided, and elastic member layers are formed on both end-portion peripheral faces of at least one of the driving rollers, the end-portion peripheral faces corresponding to both width-direction end portions of the film substrate.

Further, in this invention, the distance between elastic members and the width of each of the elastic member layers provided on both end-portion peripheral faces of at least one of the driving rollers are set so as to hold the outside of a portion of the film substrate on which the metal thin film has been formed.

According to Claim 1, elastic member layers are formed on both end-portion peripheral faces of one driving roller, so that during transport by the pair of driving rollers, the film substrate is transported with the elastic member layers in contact with both end portions of the film substrate, and the occurrence of transport wrinkles in the film substrate can be prevented. During transport the driving roller pressure-contact portions of the film substrate are limited to specific areas of both end portions of the film, so that the current-generating layer region is not scratched, and moreover the occurrence of transport wrinkles can be prevented.

### BRIEF DESCRIPTION OF THE DRAWINGS

Fig. 1 is a configuration diagram showing the thin film electrode layer formation apparatus of an embodiment of a thin film solar cell manufacturing apparatus of the invention;
Fig. 2 shows the press roller structure in an embodiment of a thin film solar cell manufacturing apparatus of the invention, in which (a) is a conceptual diagram showing the cross-sectional configuration of the press roller, and (b) is a conceptual diagram showing the dimensions and contact position of the press roller and film substrate;
Fig. 2A is a conceptual diagram showing a modified example relating to the dimensions and contact position of the press roller and film substrate in Fig. 2 (b);
Fig. 3 is a perspective view showing conceptually the configuration of a thin film solar cell of the prior art;
Fig. 4 shows simplified thin film solar cell manufacturing processes of the prior art, in which (a) through (g) are conceptual cross-sectional diagrams showing each process;
Fig. 5 is a conceptual cross-sectional view showing the configuration of a stepping roll film deposition type vacuum film deposition apparatus of the prior art;
Fig. 6 shows an example of the summary structure of a film deposition chamber of the prior art, in which (a) and (b) are summary cross-sectional views when the film deposition chamber is opened and sealed respectively; and
Fig. 7 is a conceptual diagram showing a sputtering film deposition apparatus of the prior art.

### EXPLANATION OF REFERENCE NUMERALS

- 1: Film substrate
- 2: Feedout roller
- 3: Feedout chamber
- 4: Takeup roller
- 5: Takeup chamber
- 6: Film deposition chamber
- 7: Guide roller
- 8: Intermediate chamber
- 9, 10: Auxiliary roller for driving
- 11: Heater
- 12: Ground electrode
- 13: High-voltage electrode
- 14: Feed roller (driving roller)
- 15: Press roller (driving roller)
- 16: Driving roller
- 18: Rotating member
- 21: Elastic member layer
- 22: Current-generating region
- 23: Metal thin film portion

### BEST MODE FOR CARRYING OUT THE INVENTION

Below, displayed embodiments are explained in detail, referring to the drawings.

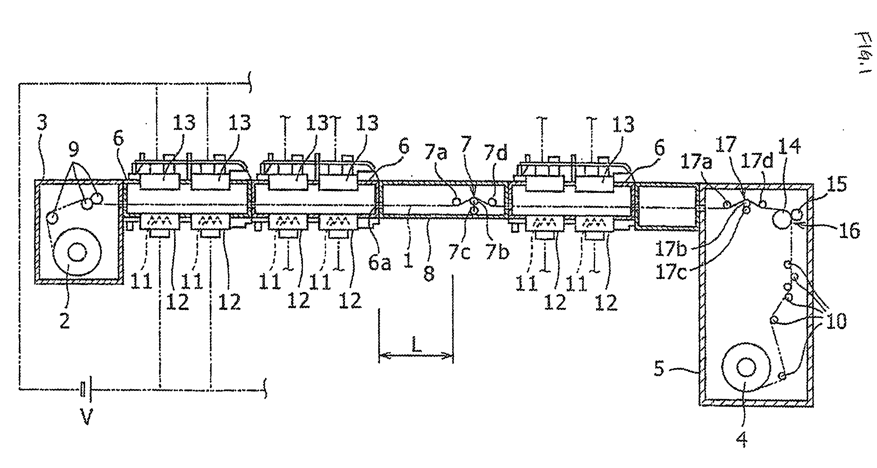

Fig. 1 shows conceptually only the basic constituent portions for thin film electrode layer formation in a solar cell manufacturing apparatus. The reaction chamber, sputtering gas supply system, evacuation system, film substrate transport means, and similar are omitted in the explanation.

In Fig. 1, the thin film electrode layer formation apparatus employs the so-called roll-to-roll method, comprising a feedout chamber 3 in which is accommodated a feedout roller 2 around which is wrapped, in roll form, the strip-shape flexible film substrate 1; a takeup chamber 5 in which is accommodated a takeup roller 4 which takes up the film substrate 1 on which has been formed the metal thin film which becomes the electrode layer; a plurality of film deposition chambers 6, arranged in a row between the feedout chamber 3 and the takeup chamber 5, which form a metal thin film on the film substrate 1; and, an intermediate chamber 8, positioned substantially at the intermediate position among the plurality of film deposition chambers 6, in which is provided a guide roller 7 which transports the film substrate 1.

The feedout roller 2 and takeup roller 4 are positioned in the vertical direction, and transport the film substrate 1, in an erect state, through the plurality of film deposition chambers 6 and the intermediate chamber 8, so that openings are formed in each of the film deposition chambers 6 to enable passage of the film substrate 1. A driving mechanism (not shown) which performs feedout and takeup of the film substrate 1 at constant velocity is incorporated into the feedout chamber 3 and takeup chamber 5. The driving mechanisms for example incorporate a motor and accelerator in the takeup chamber 5, so that driving can be performed by causing the makeup roller 4 to rotate at constant velocity. A mechanism which applies constant braking, so that the film substrate 1 is pulled in a state in which constant tension is maintained, may be comprised by the feedout chamber 3. A plurality of auxiliary rollers for driving 9, 10 are provided in the feedout chamber 3 and the takeup chamber 5 respectively, and are controlled such that transport of the film substrate 1 is maintained in the optimum state. Control of the feedout chamber 3 and takeup chamber 5 is effected by means of a control mechanism, not shown, such that a constant velocity is maintained.

A vacuum apparatus, not shown, is connected to the plurality of film deposition chambers 6 and to the intermediate chamber 8, and evacuates to vacuum so as to maintain a constant vacuum which is at least equal to or less than atmospheric pressure. In each of the plurality of film deposition chambers 6 are positioned, on the one hand, a ground electrode 12 incorporating a heater 11, and on the other hand, a high-voltage electrode 13 connected to a DC power supply v, so as to enclose the transported film substrate 1. The heaters 11 constantly heat the film substrate 1 to a temperature of approximately 300°C. The DC power supply V is connected to the ground electrodes 12 and the high-voltage electrodes 13 in each of the film deposition chambers 6, and applies a high voltage across the ground electrodes 12 and high-voltage electrodes 13.

As the high-voltage electrodes 13, metals such as for example silver, aluminum, zinc oxide, or similar, called targets, are used; discharge with the ground electrodes 12 is accompanied by the generation of metal ions, and through a vacuum evaporation method called sputtering, a thin film of the metal, which becomes an electrode, is formed on the surface of the film substrate 1.

The intermediate chamber 8 is positioned midway among the plurality of film deposition chambers 6, and the guide roller 7 to stably transport the film substrate 1 is positioned at a constant distance L from the outlet of the preceding-stage film deposition chamber 6. The guide roller 7 comprises a plurality of rollers 7a, 7b, 7c, 7d (four in the example shown), and transports the film substrate 1 in a state with tension maintained. The roller 7b applies constant tension to the film substrate 1.

The auxiliary roller for driving 9 provided in the feedout chamber 3 maintains a constant tension so that there is no slack in the film substrate 1; in this case, the film substrate 1 passes between the pair of rollers 9₁ and 9₂, so that the occurrence of slack is prevented.

Further, in the takeup chamber 5 are provided a plurality of auxiliary rollers for driving 10; driving rollers 16, comprising a feed roller 14 which maintains constant tension and transports the film substrate 1 and a press roller 15; and a guide roller 17 similar to the guide roller 7. The feed roller 14 is driven in rotation by a motor or other driving means, not shown, and with the press roller 15 in pressing contact, transports the film substrate 1 so as to maintain constant tension.

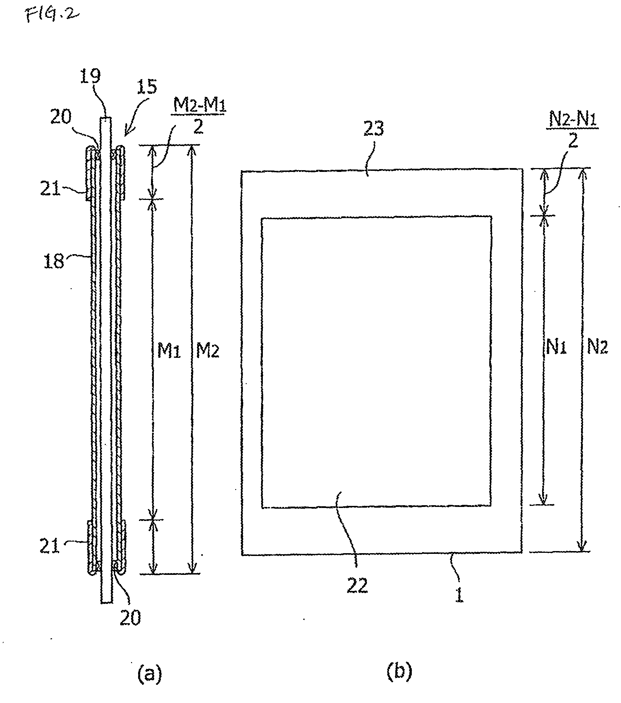

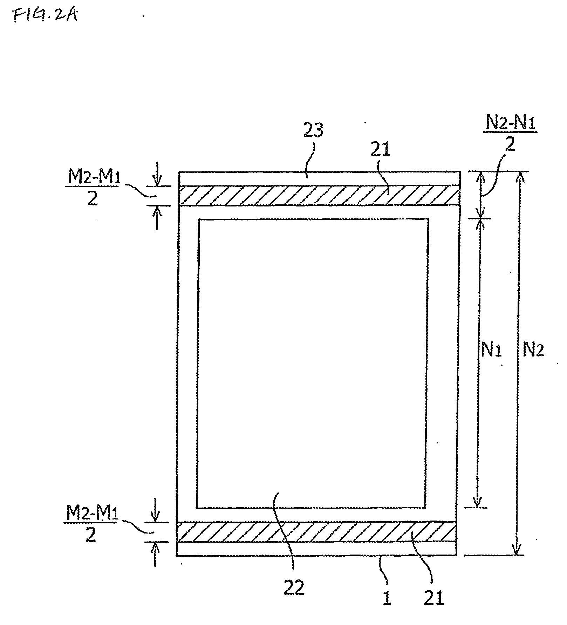

Fig. 2 is a conceptual diagram showing the structure of the press roller of a thin film solar cell manufacturing apparatus of this invention, in which (a) shows the cross-sectional configuration of the press roller 15, and (b) shows the dimensions and contact position of the press roller 15 and film substrate 1. In (b) of Fig. 2, the film substrate 1 has a metal foil film 23 formed on the surface by the thin film electrode layer formation apparatus shown in Fig. 1, and thereafter, has a current-generating region 22, in which is formed, by a plasma CVD apparatus, not shown, a photoelectric conversion layer comprising a semiconductor layer.

As shown in (a) of Fig. 2, the press roller 15 comprises a cylinder-shape rotating member 18, a shaft 19 penetrating the rotating member 18 along the axial line, and bearings 20 provided between the shaft 19 and both end-portion inner peripheral faces of the rotating member 18; on both end-portion outer peripheral faces of the rotating member 18 are provided elastic member layers 21. with a constant width. The elastic member layers 21 are formed from material such as rubber having elasticity, and the length M₁ to the elastic member layers 21 on both sides is formed to be larger than the width N₁ of the current-generating region 22 which becomes the electrode of the film substrate 1 (M₁ ≥ N₁), as shown in (a) and (b) of Fig. 2. Also, the length M₂ to the end portion of the elastic member layers 2 on both sides is set to ≥ the width N₂ of the film substrate 1. Hence M₁ is smaller than N₂, and M₁ is greater than N₁, with values set such that N₁ ≤ M₁ ≤ N₂. The width (M₂₋M₁) /2 of the elastic member 21 is set to be greater than the width (N₂-N₁)/2 of the metal thin film portion 23 on which the current-generating region 22 of the film substrate 1 is not formed.

According to the above embodiment, first, the vacuum apparatus is operated and the plurality of film deposition chambers 6 and the intermediate chamber 8 are maintained in a vacuum state. The film deposition chambers 6 are heated to a preset temperature of approximately 300°C by means of the ground electrodes 12 incorporating heaters 11, and the high-temperature vacuum state is maintained. And, by operation of the driving apparatus, the feedout roller 2 and makeup roller 4 are rotated to transport the film substrate 1 at the film transport velocity of approximately 1 m/mn. The film substrate 1 pulled out from the feedout roller 2 passes through the plurality of film deposition chambers 6 and the intermediate chamber 8, and is taken up by the takeup roller 4. The film substrate 1 which passes through the plurality of film deposition chambers 6 passes between the ground electrodes 12 and the high-voltage electrodes 13 in an erect state, and vacuum deposition onto one surface of the film substrate 1 is performed through discharge across the ground electrodes 12 and high-voltage electrodes 13, to form metal thin film.

The film substrate 1, on which metal thin film has been formed in the film deposition chambers 6, is held by the driving rollers 16, comprising the feed roller 14 and press roller 15, so as to maintain constant tension, and is transported to the takeup chamber 5 and is taken up by the takeup roller 4. At this time, by means of the elastic member layers 21 on both sides, the press roller 15 makes pressing contact with the metal thin film portion 23, on which the current-generating region 22 is not formed, against the feed roller 14 to transport the film substrate 1, so that there are no concerns that the roller portion of the press roller 15 may make direct contact with the current-generating region 22. Hence there are no concerns that transport wrinkles may be caused in the film substrate 1.

In particular, even during film fabrication on the opposite surface (back surface) of the film substrate 1 on one surface (the rear surface) of which metal thin film has already been formed, there are no concerns that the press roller 15 may make direct contact with the 00current-generating region 22, so that the occurrence of transport wrinkles can be prevented. In this way, the film substrate 1 on which metal thin film has been formed can proceed to the next process of forming the semiconductor layer.

According to the above embodiment, by means of the elastic member layers 21 on both sides of the press roller 15, the metal thin portion 23 on which the current-generating region 22 is not formed is in pressing contact with the feed roller 14 and the film substrate 1 is transported, so that there are no concerns that the press roller 15 is in direct contact with the current-generating region 22, and the width-direction tension distribution does not become non-uniform, so that there are no concerns that transport wrinkles may be caused in the film substrate 1.

This invention is not limited to the above embodiment, and for example, in Fig. 2, if the width (M₂-M₁)/2 of the elastic member layers 21 shown in Fig. 2A are made to enter into the range of the width (N₂-N₁)/₂ of the metal thin film portion 23 of the film substrate 1 on which the current-generating region 22 is not formed, then further advantageous results in wrinkle prevention are obtained. Also, of the driving rollers 16 provided in the makeup chamber 5 comprising the feed roller 14 and the press roller 15, this invention was applied to the press roller 15, but application to other roller portions is also possible.

Further, in the above embodiment, application was to a thin film electrode layer formation apparatus which forms a metal thin film on one surface; but application to a thin film electrode layer formation apparatus which forms metal thin films on both surfaces is also possible. Also, application to a thin film electrode layer formation apparatus which transports the film substrate 1 in a horizontal state is also possible. And, application to a photoelectric conversion layer formation apparatus which forms a semiconductor layer on film substrate on which a metal thin film has been formed is also possible, and in addition, various appropriate modifications are of course possible without deviating from the invention.

## Claims

1. A thin film solar cell manufacturing apparatus, in which a strip-shape flexible film substrate (1) wrapped around a feedout roller (2) is fed to a film deposition chamber (6) maintained substantially in a vacuum state, electric discharge is induced across ground electrodes (12) positioned to oppose each other and application electrodes having target material in the film deposition chamber (6), metal thin film (23) of width N2, which becomes an electrode, is formed on the surface of the film substrate (1) by constant heating, and thereafter a current-generating region (22) of width N1 is formed on the surface of the metal thin film (23), wherein N1 < N2 and the film substrate formed (1) with metal thin film is taken up by a takeup roller provided in a takeup chamber (5),
the apparatus being **characterized in that**
in the takeup chamber (5) a pair of driving rollers (16) which transport, at constant tension, the film substrate (1) formed with metal thin film (23) are provided, and elastic member layers (21) are formed on both end-portion peripheral faces of at least one of the driving rollers (16), the end-portion peripheral faces corresponding to both width-direction end portions of the film substrate (1) wherein a distance M1 between the elastic members (21) is greater than the width N1 and smaller than the width N2 so as to hold a portion of the film substrate (1) on which the current-generating region is not formed.

2. The thin film solar cell manufacturing apparatus according to Claim 1, **characterized in that** a width (M2-M1)/2 of the elastic member layers (21) provided on both end-portion peripheral faces of at least one of the driving rollers (16) is set so to be smaller than the width (N2-N1)/2 of the metal thin film portion on which the current-generating region (22) is not formed.

## Patentansprüche

1. Vorrichtung zur Herstellung einer Dünnfiim-Solarzelle, bei der ein streifenförmiges elastisches Filmsubstrat (1), das um eine Abwickelrolle (2) gewickelt ist, einer Filmabscheidungskammer (6) zugeführt wird, die im Wesentlichen in einem Vakuumzustand gehalten wird, eine elektrische Entladung über Masseelektroden (12), die so positioniert sind, dass sie einander gegenüberliegen, und Anlegungselektroden, die Zielmaterial in der Filmabscheidungskammer (6) aufweisen, induziert wird, ein Melalldünnfilm (23) der Breite N2, der zu einer Elektrode wird, auf der Oberfläche des Filmsubstrats (1) durch konstantes Erhitzen ausgebildet wird und anschließend eine Strom erzeugende Zone (22) der Breite N1 auf der Oberfläche des Metalldünnfilms (23) ausgebildet wird, wobei N1 < N2 ist und das mit dem Metalldünnfilm ausgebildete Filmsubstrat (1) von einerAufwickelrolle aufgenommen wird, die in einer Aufwickelkammer (5) vorgesehen ist,
wobei die Vorrichtung **dadurch gekennzeichnet ist, dass**
in der Aufwickelkammer (5) ein Paar Antriebsrollen (16), die das mit dem Metalldünnfilm (23) gebildete Filmsubstrat (1) mit konstantem Zug transportieren, vorgesehen und elastische Elementschichten (21) auf beiden Endabschnitt-Umfangsflächen zumindest einer der Antriebsrollen (16) ausgebildet sind, wobei die Endabschnitt-Umfangsflächen beiden Breitenrichtungs-Endabschnitten des Filmsubstrats (1) entsprechen, wobei ein Abstand M1 zwischen den elastischen Elementen (21) größer als die Breite N1 und kleiner als die Breite N2 ist, um einen Abschnitt des Filmsubstrats (1) zu halten, auf dem die Strom erzeugende Zone nicht ausgebildet ist.

2. Vorrichtung zur Herstellung einer Dünnfilm-Solarzelle nach Anspruch 1, **dadurch gekennzeichnet, dass** eine Breite (M2-M1)/2 der elastischen Elementschichten (21), die auf beiden Endabschnitt-Umfangsflächen zumindest einer derAntriebsrollen (16) vorgesehen sind, so eingestellt ist, dass sie kleiner als die Breite (N2-N1)/2 des Metalldünnfilmabschnitts ist, auf dem die Strom erzeugende Zone (22) nicht ausgebildet ist.

## Revendications

1. Dispositif de fabrication d'une pile solaire à couche mince, dans lequel un substrat (1) de film souple, en forme de bande, enroulé autour d'un rouleau (2) d'alimentation est envoyé dans une chambre (6) de dépôt d'un film maintenu sensiblement dans un état de vide, une décharge électrique est induite aux bornes d'électrodes (12) de terre disposées de manière à s'opposer l'une à l'autre et d'électrodes d'application ayant de la matière cible dans la chambre (6) de dépôt de film, un mince film (23) métallique d'une largeur N2, qui devient une électrode, est formé sur la surface du substrat (1) de film par chauffage constant et ensuite une région (22) de production de courant d'une largeur N1 est formée sur la surface du mince film (23) métallique, dans lequel N1 < N2 est le substrat de film formé (1) en ayant un mince film métallique est repris par un rouleau d'enroulement prévu dans une chambre (5) d'enroulement,
le dispositif étant **caractérisé en ce que**
dans la chambre (5) d'enroulement il est prévu une paire de rouleaux (16) d'entraînement, qui transportent, à une tension constante, le substrat (1) de film formé en ayant un mince film (23) métallique, et des couches (21) d'éléments élastiques sont formées sur les deux faces périphériques de partie d'extrémité d'au moins l'un des rouleaux (16) d'entraînement, les faces périphériques de parties d'extrémité correspondant aux deux parties d'extrémité dans la direction en largeur du substrat (1) de film, dans lequel une distance M1 entre les éléments (21) élastiques est plus grande que la largeur N1 et plus petite que la largeur N2 de manière à maintenir une partie du substrat (1) de film sur lequel la région de production de courant n'est pas formée.

2. Dispositif de fabrication de piles solaires à couches minces suivant la revendication 1, **caractérisé en ce qu'**une largeur (M2-M1)/2 des couches (2) d'éléments élastiques prévues sur les deux faces périphériques de parties d'extrémité d'au moins l'un des rouleaux (16) d'entraînement est fixée de manière à être plus petite que la largeur (N2-N1)/2 de la partie de mince film métallique sur laquelle la région (22) de production de courant n'est pas formée,
